# EUROPEAN PATENT APPLICATION

(11) **EP 3 691 039 A1**
(43) Date of publication of application: **05.08.2020**
(21) Application number: 20150040.2
(22) Date of filing: 02.01.2020
(51) Int. Cl.: H01R 12/58, H05K 3/30, H01R 4/26

(54) **PRESS-FIT TERMINAL AND BOARD WITH TERMINAL**

(30) Priority: 01.02.2019 JP 2019017182
(71) Applicant: YAZAKI CORPORATION, Minato-ku, Tokyo 108-8333 (JP)
(72) Inventor: KISHIBATA, Yuya, Makinohara-shi, Shizuoka 421-0407 (JP); SAKAMOTO, Nobuyuki, Makinohara-shi, Shizuoka 421-0407 (JP); OOYAMA, Kouichi, Makinohara-shi, Shizuoka 421-0407 (JP)
(74) Representative: Grünecker Patent- und Rechtsanwälte PartG mbB

(57) **Abstract**

A press-fit terminal (1) includes a compliant part (5) having a widened part (53) including contact points that protrude to the outermost side along an orthogonal direction (first orthogonal direction Y) orthogonal to an insertion direction X with respect to a through hole (23) of a board (20) and an open hole (8) that allows deformation of the widened part (53) toward an inside in the orthogonal direction, and is press-fitted into the through hole (23) along the insertion direction X to come into contact with an inner peripheral surface of the through hole (23) of the board (20).

## Description

### BACKGROUND OF THE INVENTION

### 1. Field of the Invention

The present invention relates to a press-fit terminal and a board with the terminal.

### 2. Description of the Related Art

As the related press-fit terminal, for example, Japanese Patent No. 4030129 discloses a compliant part, which has a leg extending from a body and having an outer edge forming a predetermined shape in an axial direction, and an elongated hole which has a predetermined shape punched transversely through a terminal, separates the leg, and is defined between inwardly facing edges.

However, the aforementioned press-fit terminal has room for improvement in terms of ensuring appropriate holding force and making appropriate electrical connection between the press-fit terminal and a board.

### SUMMARY OF THE INVENTION

The present invention has been made to solve the aforementioned problems, and an object of the present invention is to provide a press-fit terminal capable of ensuring appropriate holding force and appropriately performing electrical connection with the board and the board with a terminal.

A press-fit terminal according to one aspect of the present invention includes a widened part including contact points that protrude to an outermost side along an orthogonal direction orthogonal to an insertion direction with respect to a through hole of a board, and an open hole that allows deformation of the widened part toward an inside in the orthogonal direction, and is press-fitted into the through hole along the insertion direction to come into contact with an inner peripheral surface of the through hole of the board, wherein the widened part has a first contact point that is the contact point located on a distal end side in the insertion direction, a second contact point that is the contact point located on a proximal end side opposite to the distal end side in the insertion direction, and a low-rigidity portion that is located between the first contact point and the second contact point in the insertion direction and has a rigidity lower than rigidity of the first contact point and rigidity of the second contact point.

According to another aspect of the present invention, in the press-fit terminal, it is preferable that the compliant part includes a pair of press-fitting parts that extend along the insertion direction, are located to face each other with the open hole interposed therebetween in the orthogonal direction, and are each provided with the first contact point, the second contact point, and the low-rigidity portion, each of the pair of press-fitting parts includes an inner wall surface located on a side of the open hole in the orthogonal direction and an outer wall surface located on a side opposite to the open hole in the orthogonal direction, and in the orthogonal direction, a width dimension between the inner wall surface and the outer wall surface of the low-rigidity portion is smaller than a width dimension between the inner wall surface and the outer wall surface of the first contact point and a width dimension between the inner wall surface and the outer wall surface of the second contact point.

According to still another aspect of the present invention, in the press-fit terminal, it is preferable that the outer wall surface of the low-rigidity portion is recessed to be closed to the open hole with respect to the first contact point and the second contact point.

According to still another aspect of the present invention, in the press-fit terminal, it is preferable that the outer wall surfaces of the pair of press-fitting parts extend in parallel along the insertion direction, and the open hole has a largest width dimension in the orthogonal direction in the low-rigidity portion and a width dimension in the orthogonal direction gradually decreases as being away from the low-rigidity portion along the insertion direction.

According to still another aspect of the present invention, in the press-fit terminal, it is preferable that a coating is located on the inner peripheral surface of the through hole of the board, a when the compliant part is press-fitted into the inner peripheral surface of the through hole, the coating is scraped off by the first contact point.

According to still another aspect of the present invention, in the press-fit terminal, it is preferable that an interval along the insertion direction between the first contact point and the second contact point is 70% to 100% of a depth dimension of the through hole in the insertion direction.

A board with a terminal according to still another aspect of the present invention includes a board having a through hole; and a press-fit terminal press-fitted into the through hole, wherein the press-fit terminal includes a compliant part that includes a widened part including contact points that protrude to an outermost side along an orthogonal direction orthogonal to an insertion direction with respect to the through hole of the board; and an open hole that allows deformation of the widened part toward an inside in the orthogonal direction, and is press-fitted into the through hole along the insertion direction to come into contact with an inner peripheral surface of the through hole of the board, and the widened part has a first contact point that is the contact point located on a distal end side in the insertion direction, a second contact point that is the contact point located on a proximal end side opposite to the distal end side in the insertion direction, and a low-rigidity portion that is located between the first contact point and the second contact point in the insertion direction and has a rigidity lower than rigidity of the first contact point and rigidity of the second contact point.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a front view of a press-fit terminal according to a first embodiment of the present invention;
FIG. 2 is a front view illustrating a state in which a compliant part of the press-fit terminal is press-fitted into a through hole of a board;
FIG. 3 is a sectional view taken along an arrow III-III of FIG. 2;
FIG. 4 is a front view of a press-fit terminal according to a second embodiment of the present invention;
FIG. 5 is a front view of a press-fit terminal according to a third embodiment of the present invention;
FIG. 6 is a front view of a press-fit terminal according to a fourth embodiment of the present invention; and
FIG. 7 is a front view of a press-fit terminal according to a fifth embodiment of the present invention.

### DETAILED DESCRIPTION OF THE PREFERRED EMBODIMENTS

Hereinafter, embodiments of a press-fit terminal and a board with the terminal according to the present invention will be described on the basis of the drawings. The present invention is not limited to the embodiments.

### First Embodiment

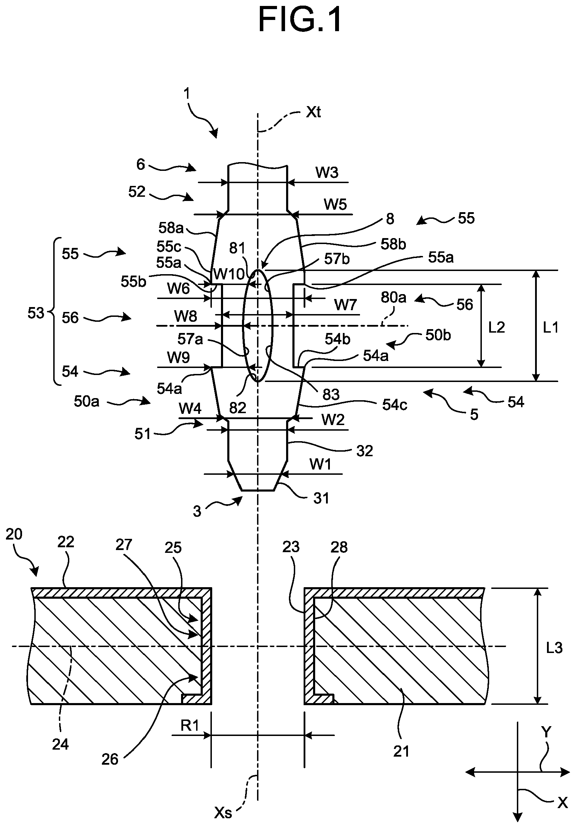

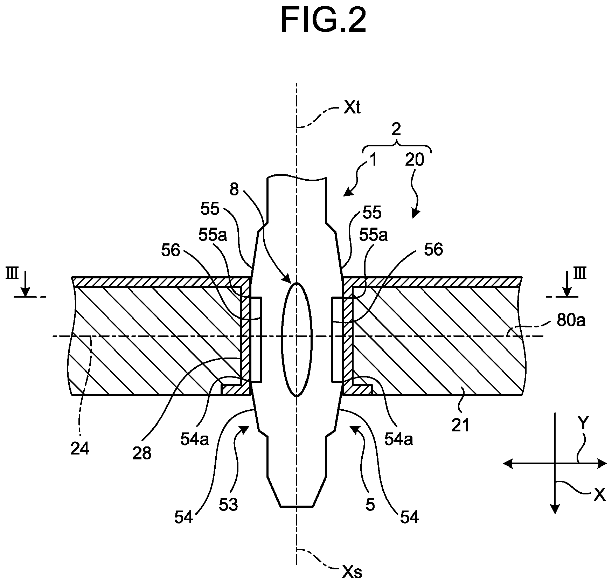

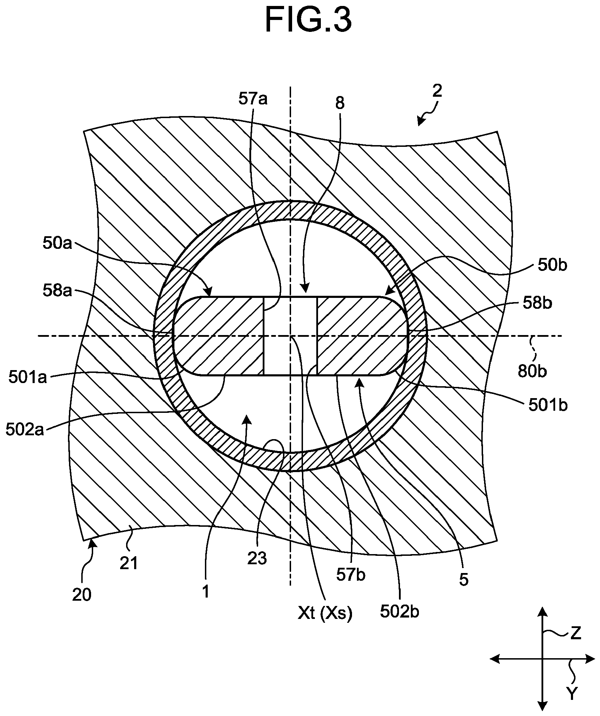

FIG. 1 is a front view of a press-fit terminal according to the present invention. FIG. 2 is a front view illustrating a state in which a compliant part of the press-fit terminal is press-fitted into a through hole of a board. FIG. 3 is a sectional view taken along an arrow III-III of FIG. 2.

As illustrated in FIG. 1, an X direction is an insertion direction of a press-fit terminal 1 into a through hole 23 of a board 20 in the present embodiment. A Y direction is a first orthogonal direction (orthogonal direction) of the press-fit terminal 1 orthogonal to the insertion direction X. A Z direction is a second orthogonal direction of the press-fit terminal 1 orthogonal to the insertion direction X and the first orthogonal direction Y, as illustrated in FIG. 3. In the present specification, the press-fit terminal 1 has a distal end side along the insertion direction X and a proximal end side located on an opposite side of the insertion direction X.

The press-fit terminal 1 according to the present embodiment is used for the board 20 such as a printed board, for example. As illustrated in FIG. 1, the board 20 has an electrically insulating board body 21. The board body 21 has an electrically conductive circuit section 22 and the through hole 23 electrically connected to the circuit section 22. The circuit section 22, for example, is disposed on one surface (mounting surface) of the board 20 in the insertion direction X. The through hole 23 is formed in a columnar shape having a through axis Xs, for example, so as to pass through the board body 21 in the insertion direction X. The through hole 23 is formed such that a diameter R1 is constant in the insertion direction X. An inner peripheral surface of the through hole 23 is covered by a conductive part 28 that is an electrically conductive material. Furthermore, the through hole 23 has an end portion 25 on the proximal end side in the insertion direction X, an end portion 26 on the distal end side in the insertion direction X, and a central portion 27 between the end portion 25 and the end portion 26. A depth dimension L3 of the through hole 23 in the insertion direction X is a length from a proximal end at the end portion 25 to a distal end at the end portion 26 in the insertion direction X. In other words, the depth dimension L3 of the through hole 23 in the insertion direction X is a length of a part having the same diameter R1. The press-fit terminal 1 and the board 20 constitute a board with the terminal 2 (see FIG. 2). In other words, the board with the terminal 2 includes the press-fit terminal 1 and the board 20.

For example, as illustrated in FIG. 1, the press-fit terminal 1 has an axial center Xt made of an electrically conductive material such as a copper alloy and extending along the insertion direction X and includes a distal end section 3, a compliant part 5, and a proximal end section 6. The press-fit terminal 1 is formed to extend along the insertion direction X, and in the insertion direction X, the board 20 is connected to the distal end section, which is an end section on one side (distal end side), via the compliant part 5 and the like and a connection counterpart (object to be electrically connected to the board 20) is connected to the proximal end section, which is an end section on the other side (proximal end side). A plating layer made of tin plating, silver plating, gold plating, and the like may be formed on the surface of the press-fit terminal 1.

The distal end section 3 is a section located on the most distal end side of the press-fit terminal 1, and has a first part 31 and a second part 32. The first part 31 is a part that extends in a direction opposite to the insertion direction X such that a width direction W1 gradually increases toward the proximal end side from the distal end side. The second part 32 is a part that is located on the proximal end side of the first part 31, extends along the insertion direction X, has an identical width dimension W2 in the first orthogonal direction Y, and extends along the insertion direction X. The width dimension W1 of the first part 31 in the first orthogonal direction Y and the width dimension W2 of the second part 32 in the first orthogonal direction Y are smaller than the diameter R1 of the through hole 23. Thus, the distal end section 3 can be inserted into the through hole 23.

The proximal end section 6 is located on the most proximal end side of the press-fit terminal 1, and is formed to extend in the insertion direction X such that a width dimension W3 in the first orthogonal direction Y is the same in the insertion direction X.

The compliant part 5 is disposed so as to be adjacent to the proximal end side of the distal end section 3 and adjacent to the distal end side of the proximal end section 6 in the insertion direction X. A width dimension of the compliant part 5 in the first orthogonal direction Y is larger than the width dimensions W1 and W2 of the distal end section 3 in the first orthogonal direction Y and is larger than the width dimension W3 of the proximal end section 6 in the first orthogonal direction Y. The compliant part is a part that is press-fitted into the through hole 23.

The compliant part 5 has an introduction part 51 located on the distal end side, a terminal part 52 located on the proximal end side, and a widened part 53 located between the introduction part 51 and the terminal part 52, in the insertion direction X.

The introduction part 51 is disposed to be adjacent to the distal end section 3 and is a part whose width dimension W4 in the first orthogonal direction Y gradually increases toward the proximal end side from the distal end side.

The terminal part 52 is disposed to be adjacent to the proximal end section 6 and is a part whose width dimension W5 in the first orthogonal direction Y gradually increases toward the distal end side from the proximal end side.

The widened part 53 has a first contact point portion 54 adjacent to the introduction part 51, a second contact point portion 55 adjacent to the terminal part 52, and a low-rigidity portion 56 located between the first contact point portion 54 and the second contact point portion 55, and extends along the insertion direction X. The first contact point portion 54 and the second contact point portion 55 are contact point portions that protrude outward along the first orthogonal direction Y in the press-fit terminal 1. In the widened part 53, a width dimension W6 of portions corresponding to the first contact point portion 54 and the second contact point portion 55 (more specifically, portions of a first contact point 54a and a second contact point 55a to be described below) in the first orthogonal direction Y are slightly larger than the diameter R1 of the through hole 23. Furthermore, in the widened part 53, a width dimension W7 of a portion corresponding to the low-rigidity portion 56 in the first orthogonal direction Y is smaller than the width dimension W6.

The compliant part 5 is bifurcated by having an open hole 8 located in the center of the first orthogonal direction Y and extending along the insertion direction X. That is, the compliant part 5 has a pair of press-fitting parts 50a and 50b that extend along the insertion direction X and are located to face each other with the open hole 8 interposed therebetween in the first orthogonal direction Y. Each of the pair of press-fitting parts 50a and 50b is a part extending in a columnar shape along the insertion direction X, and is formed to be curved in such a manner as to protrude toward an opposite side (that is, outside with respect to the first orthogonal direction Y) to the open hole 8 with respect to the first orthogonal direction Y. In the pair of press-fitting parts 50a and 50b, the press-fitting part 50a and the press-fitting part 50b face each other in the first orthogonal direction Y. The pair of press-fitting parts 50a and 50b are each provided with the first contact point portion 54, the second contact point portion 55, and the low-rigidity portion 56.

As illustrated in FIG. 1, when viewed from the front, the open hole 8 has a vertically long approximately elliptical shape along the insertion direction X and is formed to pass through the compliant part 5 along the second orthogonal direction Z as illustrated in FIG. 3. The open hole 8 has approximately the same thickness dimension in the second orthogonal direction Z, and allows the widened part 53 to be deformed inward in the first orthogonal direction Y.

As illustrated in FIG. 1, the open hole 8 is located on the proximal end side in the insertion direction X, and has a semicircular upper portion 81 whose width dimension in the first orthogonal direction Y gradually increases along the insertion direction X. Furthermore, the open hole 8 is located on the distal end side in the insertion direction X, and has a lower portion 82 whose width dimension in the first orthogonal direction Y gradually increases along a direction opposite to the insertion direction X. Moreover, the open hole 8 has a central portion 83 that is located between the upper portion 81 and the lower portion 82 and connects the upper portion 81 and the lower portion 82 in the insertion direction. The central portion 83 includes a first central position 80a in the insertion direction X of the open hole 8.

A length dimension L1 in the insertion direction X of the open hole 8 is longer than an interval L2 along the insertion direction X between the first contact point 54a and the second contact point 55a to be described below. In addition, the open hole 8 extends along the insertion direction X beyond the first contact point 54a and the second contact point 55a.

As illustrated in FIG. 1, the open hole 8 is formed to be approximately line-symmetrical with respect to a plane including the insertion direction X and the first orthogonal direction Y with respect to the first central position 80a. Moreover, as illustrated in FIG. 3, the open hole 8 has a second central position 80b in the second orthogonal direction Z, and is formed to be approximately line-symmetrical with respect to a plane including the first orthogonal direction Y and the second orthogonal direction Z with respect to the second central position 80b.

As illustrated in FIG. 3, the press-fitting parts 50a and 50b have inner wall surfaces 57a and 57b that face each other in the first orthogonal direction Y via the open hole 8, respectively. That is, the press-fitting parts 50a and 50b have the inner wall surfaces 57a and 57b inside with respect to the first orthogonal direction Y. Furthermore, the press-fitting parts 50a and 50b have outer wall surfaces 58a and 58b outside with respect to the first orthogonal direction Y, respectively. In other words, the pair of press-fitting parts 50a and 50b have the inner wall surfaces 57a and 57b located on the open hole 8 side in the first orthogonal direction Y, respectively, and the outer wall surfaces 58a and 58b located on the opposite side to the open hole 8 in the first orthogonal direction Y, respectively.

The inside of the first orthogonal direction Y is a side adjacent to the open hole 8 in the first orthogonal direction Y and a side close to the axial center Xt, and the outside of the first orthogonal direction Y is an opposite side of the open hole 8 in the first orthogonal direction Y and a side away from the axial center Xt.

As illustrated in FIG. 3, the press-fitting part 50a has a side portion 501a located outside with respect to the first orthogonal direction Y and a body portion 502a located inside the side portion 501a in the first orthogonal direction Y, and the press-fitting part 50b has a side portion 501b located outside with respect to the first orthogonal direction Y and a body portion 502b located inside the side portion 501b in the first orthogonal direction Y.

Both the side portions 501a and 501b have the outer wall surfaces 58a and 58b having the smallest thickness dimension in the second orthogonal direction Z and are portions whose thickness dimensions in the second orthogonal direction Z gradually increase as approaching the inner wall surfaces 57a and 57b along the first orthogonal direction Y from the outer wall surfaces 58a and 58b. Both the side portions 501a and 501b have the same width dimension in the first orthogonal direction Y and are formed to extend along the insertion direction X.

The body portions 502a and 502b have the same thickness dimension in the second orthogonal direction Z and are formed to extend along the insertion direction X.

The pair of press-fitting parts 50a and 50b are formed to be approximately line-symmetrical with respect to the axial center Xt. Therefore, the one press-fitting part 50a will be described below and a description of the other press-fitting part 50b will be omitted. However, the configuration of the one press-fitting part 50a and the configuration of the other press-fitting part 50b are the same. As described above, the one press-fitting part 50a is provided with the first contact point portion 54, the second contact point portion 55, and the low-rigidity portion 56. Hereinafter, the first contact point portion 54, the second contact point portion 55, and the low-rigidity portion 56 will be described in detail.

The first contact point portion 54 is located on the distal end side in the insertion direction X in the widened part 53. The first contact point portion 54 has the first contact point 54a that is located adjacent to the proximal end side of the low-rigidity portion 56 in the insertion direction X and protrudes to the outermost side along the first orthogonal direction Y, and gradually approaches the axial center Xt as approaching the distal end side along the insertion direction X from the first contact point 54a. The first contact point 54a is formed to form an acute angle by a first straight line portion 54b and a second straight line portion 54c intersecting each other. The first straight line portion 54b is orthogonal to the axial center Xt and extends linearly away from the axial center Xt, starting from an end portion on the distal end side of the low-rigidity portion 56. The second straight line portion 54c extends linearly so as to be inclined with respect to the insertion direction X and the first orthogonal direction Y, starting from an end portion on the proximal end side of the introduction part 51. The outer wall surface 58a of the first contact point portion 54 protrudes away from the open hole 8 with respect to the outer wall surface 58a of the low-rigidity portion 56.

The second contact point portion 55 is located on the proximal end side opposite to the distal end side in the insertion direction X in the widened part 53. The second contact point portion 55 has the second contact point 55a that is located adjacent to the distal end side of the low-rigidity portion 56 in the insertion direction X and protrudes to the outermost side along the first orthogonal direction Y, and gradually approaches the axial center Xt as approaching the proximal end side along a direction opposite to the insertion direction X from the second contact point 55a. The second contact point 55a is formed to form an acute angle by a third straight line portion 55b and a fourth straight line portion 55c intersecting each other. The third straight line portion 55b is orthogonal to the axial center Xt and extends linearly away from the axial center Xt, starting from an end portion on the proximal end side of the low-rigidity portion 56. The fourth straight line portion 55c extends linearly so as to be inclined with respect to the insertion direction X and the first orthogonal direction Y, starting from an end portion on the distal end side of the terminal part 52, and then extends linearly along the insertion direction X so as to be parallel with the axial center Xt. The outer wall surface 58a of the second contact point portion 55 protrudes away from the open hole 8 with respect to the outer wall surface 58a of the low-rigidity portion 56.

The interval L2 along the insertion direction X between the first contact point 54a and the second contact point 55a is 70% to 100% of the depth dimension L3 of the through hole 23 in the insertion direction X. The interval L2 along the insertion direction X between the first contact point 54a and the second contact point 55a is a length dimension from an end portion on the proximal end side of the first contact point portion 54 to an end portion on the distal end side of the second contact point portion 55 in the insertion direction X. In other words, in the insertion direction X, the interval L2 along the insertion direction X between the first contact point 54a and the second contact point 55a is a dimension slightly larger than the dimension of the low-rigidity portion 56 in the insertion direction X.

The low-rigidity portion 56 is located between the first contact point portion 54 and the second contact point portion 55 in the widened part 53. The outer wall surface 58a of the low-rigidity portion 56 is recessed to be close to the open hole 8 with respect to the first contact point portion 54 and the second contact point portion 55. Furthermore, in the insertion direction X, the center position of the low-rigidity portion 56 coincides with the first central position 80a of the open hole 8. The open hole 8 has the largest width dimension at the center position of the low-rigidity portion 56 in the insertion direction X, and its width dimension in the first orthogonal direction Y gradually decreases as being away from the center position of the low-rigidity portion 56 along the insertion direction X.

Since the press-fitting part 50a is formed as described above, a width dimension W8 between the inner wall surface 57a and the outer wall surface 58a of the low-rigidity portion 56 is smaller than a width dimension W9 between the inner wall surface 57a and the outer wall surface 58a of the first contact point 54a and a width dimension W10 between the inner wall surface 57a and the outer wall surface 58a of the second contact point 55a. In this way, the rigidity of the low-rigidity portion 56 is lower than that of the first contact point 54a and that of the second contact point 55a.

When this press-fit terminal 1 is attached to the board 20, an operator first matches the through axis Xs of the through hole 23 with the axial center Xt of the press-fit terminal 1 as illustrated in FIG. 1. Next, the operator inserts the distal end section 3 into the through hole 23.

In the press-fit terminal 1, the width dimension W6 in the widened part 53 is slightly larger than the diameter R1 of the through hole 23. Therefore, when the operator inserts the press-fit terminal 1 into the through hole 23 along the insertion direction X, the outer wall surfaces 58a of the press-fitting parts 50a and 50b and the inner peripheral surface of the through hole 23 come into contact with each other.

Thereafter, when the operator further inserts the compliant part 5 into the through hole 23 along the insertion direction X, the press-fitting parts 50a and 50b of the compliant part 5 are deformed and the compliant part 5 is press-fitted into the through hole 23. More Specifically, the pair of press-fitting parts 50a and 50b are deformed to approach each other in the first orthogonal direction Y and the width dimension of the open hole 8 in the first orthogonal direction Y becomes small. As illustrated in FIG. 2, the operator press-fits the compliant part 5 into the through hole 23 up to a position at which the first central position 80a of the open hole 8 in the insertion direction X and a center position 24 of the through hole 23 in the insertion direction X coincide with each other, so that the attachment of the press-fit terminal 1 to the board 20 is completed.

The press-fit terminal 1 and the board with the terminal 2 according to the present embodiment have the following configuration. The widened part 53 has the first contact point 54a that is a contact point located on the distal end side in the insertion direction X, the second contact point 55a that is a contact point located on the proximal end side opposite to the distal end side in the insertion direction X, and the low-rigidity portion 56 that is located between the first contact point 54a and the second contact point 55a in the insertion direction X and has a rigidity lower than that of the first contact point 54a and that of the second contact point 55a. Therefore, the rigidity of the first contact point 54a and the rigidity of the second contact point 55a are higher than that of the low-rigidity portion 56. Thus, in the press-fit terminal 1, when the compliant part 5 is press-fitted into the through hole 23, the amount of deformation of the low-rigidity portion 56 toward the inside of the open hole 8 is large and the amount of deformation of the first contact point 54a toward the inside of the open hole 8 and the amount of deformation of the second contact point 55a toward the inside of the open hole 8 are small. Therefore, the first contact point 54a and the second contact point 55a bite into the inner peripheral surface of the through hole 23. As a consequence, it is possible to reliably form contact points for electrical connection between the first contact point 54a and the board 20 and between the second contact point 55a and the board 20, and thus it is possible to appropriately perform electrical connection with the board 20. In addition, since the first contact point 54a and the second contact point 55a bite into the inner peripheral surface of the through hole 23, it is possible to achieve appropriate holding force with respect to the board 20. Meanwhile, when the press-fit terminal 1 and the board with the terminal 2 are mounted on a vehicle, vibration due to the traveling of the vehicle is applied to the press-fit terminal 1 and the board with the terminal 2. In the press-fit terminal of the present embodiment, the first contact point 54a and the second contact point 55a bite into the inner peripheral surface of the through hole 23, so that it is possible to maintain appropriate holding force with respect to the board 20 even in a state in which vibration is applied to the board 20.

In the first orthogonal direction Y, the width dimension W8 between the inner wall surface 57a and the outer wall surface 58a of the low-rigidity portion 56 is smaller than the width dimension W9 between the inner wall surface 57a and the outer wall surface 58a of the first contact point 54a and the width dimension W10 between the inner wall surface 57a and the outer wall surface 58a of the second contact point 55a. Therefore, in the press-fit terminal 1, the rigidity of the low-rigidity portion 56 can be made lower than that of the first contact point 54a and that of the second contact point 55a. Therefore, the press-fit terminal 1 can be easily manufactured by press molding and the like by simplifying the shape of the press-fitting part 50a.

The outer wall surface 58a of the low-rigidity portion 56 is recessed to be close to the open hole 8 with respect to the outer wall surface 58a of the first contact point 54a and the outer wall surface 58a of the second contact point 55a. In the press-fit terminal 1, by changing the shapes of the outer wall surface 58a of the low-rigidity portion 56, and the outer wall surface 58a of the first contact point 54a and the outer wall surface 58a of the second contact point 55a, the rigidity of the first contact point 54a and the rigidity of the second contact point 55a, and the rigidity of the low-rigidity portion 56 can be easily made different from each other. Therefore, for example, the press-fit terminal 1 can be manufactured by press-molding a metallic plate material, so that the press-fit terminal 1 can be easily manufactured.

Since the second contact point 55a has an acute angle, the second contact point 55a further bites into the inner peripheral surface of the through hole 23. Therefore, it is possible to reliably form a contact point with the board 20, so that it is possible to more appropriately perform electrical connection with the board 20.

The interval L2 along the insertion direction X between the first contact point 54a and the second contact point 55a is 70% to 100% of the depth dimension L3 of the through hole 23 in the insertion direction X. Since the interval L2 along the insertion direction X between the first contact point 54a and the second contact point 55a is 70% or more of the depth dimension L3 of the through hole 23 in the insertion direction X, even though the position of the press-fit terminal 1 in the insertion direction X with respect to the through hole 23 deviates within the tolerance range of the through hole 23 during press-fitting, the deviation is allowed, so that it is possible to reliably form contact points for electrical connection between the first contact point 54a and the board 20 and between the second contact point 55a and the board 20. On the other hand, the interval L2 is 100% or less of the depth dimension L3 of the through hole 23 in the insertion direction X, so that it is possible to prevent an increase in the size of the press-fit terminal 1. As a consequence, it is possible to appropriately perform electrical connection between the press-fit terminal 1 and the board 20 and to prevent an increase in the size of the press-fit terminal 1.

### Second Embodiment

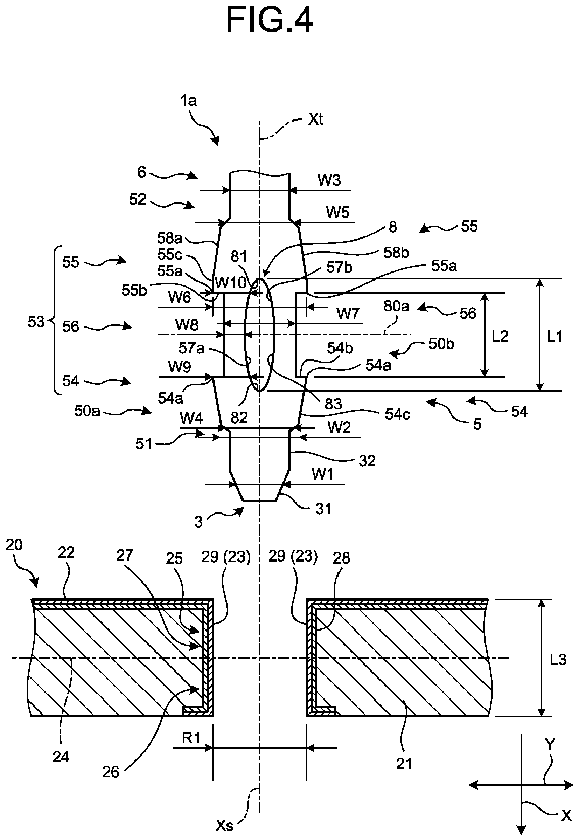

Next, a second embodiment of a press-fit terminal 1a will be described using FIG. 4. In the press-fit terminal 1a of the second embodiment, the same components, parts, and the like as those of the press-fit terminal 1 of the first embodiment are denoted by the same reference numerals, a description thereof will be omitted, and only different components and parts will be described.

The board 20 of the second embodiment is different from the board 20 of the first embodiment only in the surface of the circuit section 22 and the surface of the inner peripheral surface of the through hole 23. More specifically, the board 20 has a coating 29 that covers the surface of the circuit section 22 and the surface of the inner peripheral surface of the through hole 23. The coating 29 is formed on the surface of an electrically conductive part such as copper forming the circuit section 22 and the inner peripheral surface of the through hole 23. The coating 29 is made of an insulating material such as water-soluble preflux (what is called OSP), for example. The coating 29 can prevent the circuit section 22 and the inner peripheral surface of the through hole 23 from being oxidized and improve solderability when attaching other electronic parts to the circuit section 22 and the like. Furthermore, the frictional coefficient of the coating 29 is smaller than that of the conductive part 28 that covers the inner peripheral surface of the through hole 23.

When the compliant part 5 is press-fitted into the inner peripheral surface of the through hole 23, the first contact point portion 54 first enters the inside of the through hole 23. Then, the coating 29 inside the through hole 23 is scraped off by the first contact point 54a included in the first contact point portion 54. Before the first contact point portion 54 exits from the inside of the through hole 23, the second contact point portion 55 enters the inside of the through hole 23.

In the press-fit terminal 1a, the insulating coating 29 is scraped off by the first contact point 54a, so that the conductive part 28 having conductivity can be exposed to the inner peripheral surface of the through hole 23. Therefore, in the press-fit terminal 1a, it is possible to ensure a relatively wide contact area between the conductive part 28 having conductivity and the second contact point 55a, so that it is possible to prevent electrical resistance and improve electrical conductivity with the board 20. Furthermore, in the press-fit terminal 1a of the present embodiment, the coating 29 having a small frictional coefficient is scraped off by the first contact point 54a of the widened part 53, so that the conductive part 28 having a large frictional coefficient can be exposed to the inner peripheral surface of the through hole 23. As a consequence, the press-fit terminal 1 can bring the conductive part 28 having a large frictional coefficient into contact with the second contact point 55a in the state of being press-fitted into the through hole 23, so that it is possible to improve holding force with the board 20. In such a case, as described above, since the press-fit terminal 1a has a structure in which the amount of deformation of the low-rigidity portion 56 toward the inside of the open hole 8 is large and the amount of deformation of the first contact point 54a toward the inside of the open hole 8 is small, it is possible to improve the effect of scraping the coating 29 by the first contact point 54a.

Since the first contact point 54a has an acute angle, the first contact point 54a bites into the inner peripheral surface of the through hole 23. Therefore, in the press-fit terminal 1a, it is possible to reliably scrape off the coating 29 by the first contact point 54a during press-fitting. Therefore, in the press-fit terminal 1a, it is possible to further ensure a relatively wide contact area between the conductive part 28 having conductivity and the second contact point 55a, so that it is possible to further prevent electrical resistance and further improve electrical conductivity with the board 20.

In the press-fit terminal 1a, the interval L2 along the insertion direction X between the first contact point 54a and the second contact point 55a is 70% to 100% of the depth dimension L3 of the through hole 23 in the insertion direction X. When the compliant part 5 is press-fitted into the inner peripheral surface of the through hole 23 and the coating 29 is scraped off by the first contact point 54a, since the first contact point 54a is deformed toward the open hole 8 side located inside with respect to the first orthogonal direction Y, force for scraping off the coating 29 is reduced. Thereafter, in the press-fit terminal 1a, the coating 29 is scraped off by a part adjacent to the proximal end side of the first contact point 54a and deformation of the widened part 53 toward the open hole 8 side and scraping of the coating 29 by the widened part 53 are continued. In the press-fit terminal 1a of the second embodiment, since the interval L2 is large, it is possible to scrape off the coating 29 beyond the center position 24 of the through hole 23 in the insertion direction X, so that it is possible to reliably form an electrical contact point between the press-fit terminal 1a and the board 20. Consequently, the press-fit terminal 1a can appropriately perform electrical connection with the board 20.

### Third Embodiment

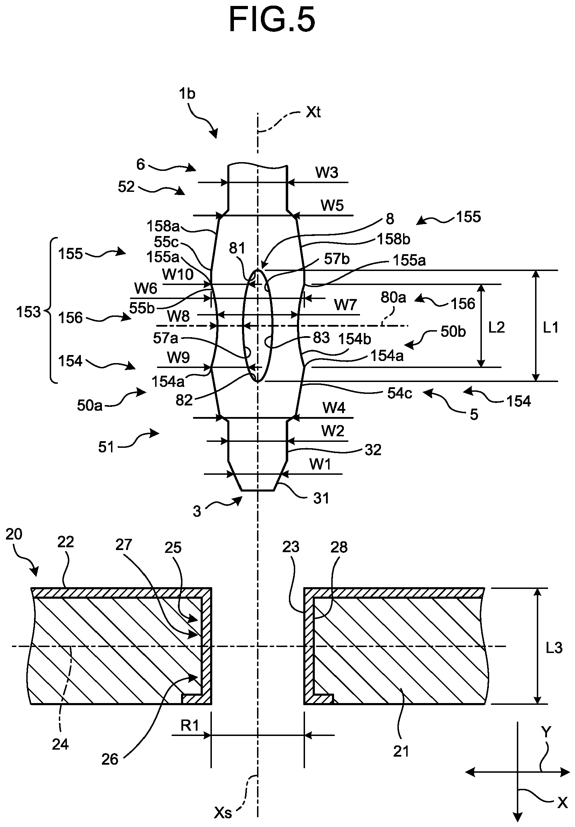

Next, a third embodiment of a press-fit terminal 1b will be described using FIG. 5. In the press-fit terminal 1b of the third embodiment, the same components, parts, and the like as those of the press-fit terminal 1 of the first embodiment are denoted by the same reference numerals, a description thereof will be omitted, and only different components and parts will be described.

In the press-fit terminal 1b of the third embodiment, only the shape of a low-rigidity portion 156 is different from that of the low-rigidity portion 56 in the press-fit terminal 1 of the first embodiment.

An outer wall surface 158a (158b) of the low-rigidity portion 156 connects a first contact point 154a and a second contact point 155a in an arc shape. More specifically, as the outer wall surface 158a at the center position of the low-rigidity portion 156 in the insertion direction X is closest to the axial center Xt and is separated from the center position along the insertion direction X and is separated along a direction opposite to the insertion direction X, a distance between the outer wall surface 158a of the low-rigidity portion 156 and the axial center Xt gradually increases.

As described above, the outer wall surface 158a (158b) of the low-rigidity portion 156 is formed, so that an angle of the first contact point 154a of the press-fit terminal 1b can be made larger than that of the first contact point 54a of the press-fit terminal 1. In addition, the area of the distal end-side portion of the low-rigidity portion 156 of the press-fit terminal 1b is larger than that of the distal end-side portion of the low-rigidity portion 56 of the press-fit terminal 1. Therefore, the rigidity of the distal end-side portion of the low-rigidity portion 156 of the press-fit terminal 1b is higher than that of the distal end-side portion of the low-rigidity portion 56 of the press-fit terminal 1. Consequently, in the press-fit terminal 1b, the rigidity of the distal end-side portion of the low-rigidity portion 156 increases, so that this portion can decrease the amount of deformation toward the open hole 8 side located inside with respect to the first orthogonal direction during press-fitting. As a consequence, the amount of deformation of the distal end-side portion of the low-rigidity portion 156 adjacent to the first contact point 154a can be reduced, so that the amount of deformation of the first contact point 154a can further be reduced. Thus, the first contact point 154a further bites into the inner peripheral surface of the through hole 23. As a consequence, it is possible to reliably form a contact point for electrical connection between the first contact point 154a and the board 20, so that it is possible to more appropriately perform electrical connection with the board 20. In addition, the first contact point 154a bites into the inner peripheral surface of the through hole 23, so that it is possible to achieve more appropriate holding force with respect to the board 20. In the press-fit terminal 1b, the proximal end-side portion of the low-rigidity portion 156 and the second contact point 155a have the same operation effects as the distal end-side portion of the low-rigidity portion 156 and the first contact point 154a.

### Fourth Embodiment

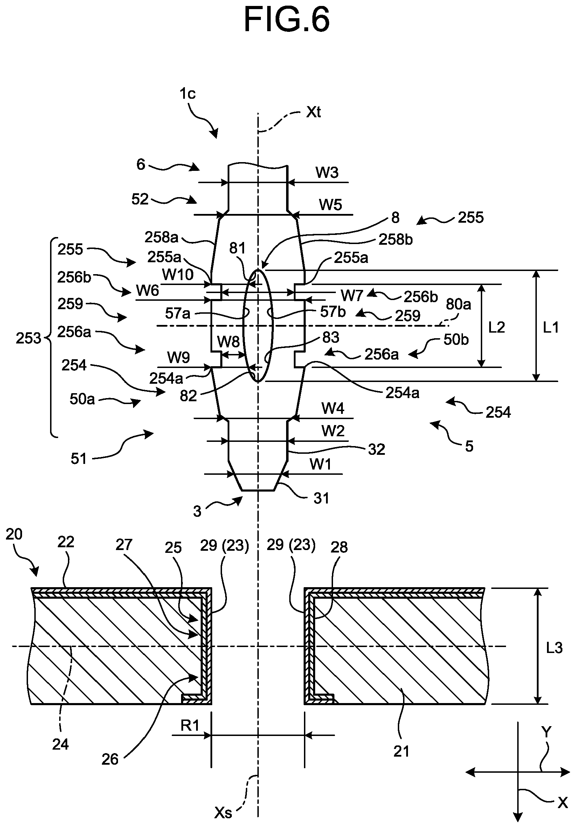

Next, a fourth embodiment of a press-fit terminal 1c will be described using FIG. 6. In the press-fit terminal 1c of the forth embodiment, the same components, parts, and the like as those of the press-fit terminal 1 of the first embodiment are denoted by the same reference numerals, a description thereof will be omitted, and only different components and parts will be described.

A widened part 253 of the press-fit terminal 1c of the forth embodiment is different from the widened part 53 of the press-fit terminal 1 of the first embodiment in that the widened part 253 further has a third contact point portion 259 between a first contact point portion 254 and a second contact point portion 255 in the insertion direction X.

The width dimension W6 of the widened part 253 including the third contact point portion 259 in the first orthogonal direction Y is the same as the width dimension W6 of the widened part 253 including a first contact point 254a in the first orthogonal direction Y and the width dimension W6 of the widened part 253 including a second contact point 255a in the first orthogonal direction Y. The third contact point portion 259 has the same width dimension W6 in the first orthogonal direction Y and extends along the insertion direction X.

Since the widened part 253 of the press-fit terminal 1c has the third contact point portion 259, the widened part 253 has two low-rigidity portions. More specifically, the widened part 253 has a first low-rigidity portion 256a located between the first contact point portion 254 and the third contact point portion 259 and a second low-rigidity portion 256b located between the third contact point portion 259 and the second contact point portion 255, in the insertion direction X. In other words, the widened part 253 of the press-fit terminal 1c has the first contact point portion 254, the second contact point portion 255, the third contact point portion 259, the first low-rigidity portion 256a, and the second low-rigidity portion 256b, and extends along the insertion direction X.

When the widened part 253 of the press-fit terminal 1c is press-fitted into the through hole 23 of the board 20 having the coating 29 and the coating 29 is scraped off by the first contact point 254a, since the first contact point 254a is deformed toward the open hole 8 side located inside with respect to the first orthogonal direction Y, force for scraping off the coating 29 is reduced. Thereafter, in the press-fit terminal 1c, the coating 29 is scraped off by a portion adjacent to the first contact point 254a. Thereafter, when the scraping force of all portions of the first contact point 254a is reduced, the coating 29 is scraped off by the third contact point portion 259. Similarly to the first contact point portion 254, deformation of a portion of the third contact point portion 259 toward the open hole 8 side and scraping of the coating 29 by a portion of the third contact point portion 259 are continued. In the press-fit terminal 1c of the fourth embodiment can improve force for scraping off the coating 29 by the third contact point portion 259 located between the first contact point portion 254 and the second contact point portion 255. As a consequence, it is possible to more reliably form an electrical contact point between the press-fit terminal 1c and the board 20. Consequently, the press-fit terminal 1c can more appropriately perform electrical connection with the board 20.

### Fifth Embodiment

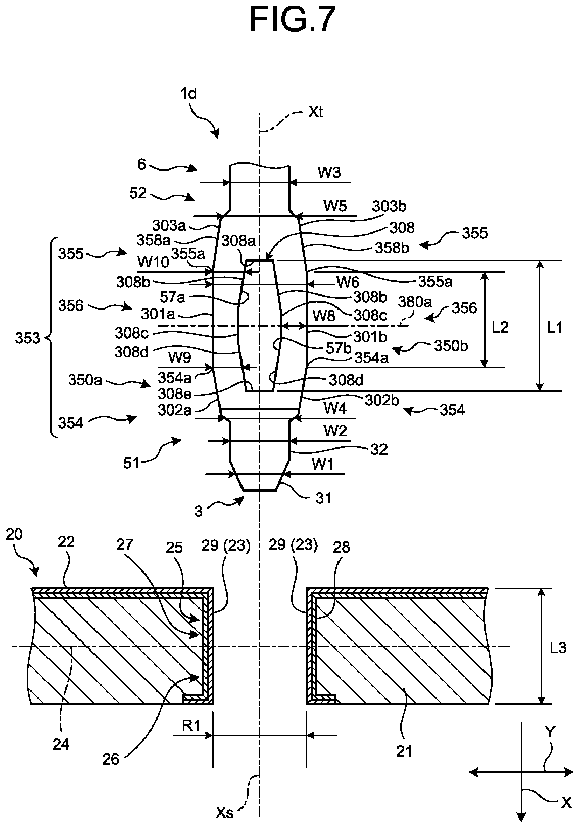

Next, a fifth embodiment of a press-fit terminal 1d will be described using FIG. 7. In the press-fit terminal 1d of the fifth embodiment, the same components, parts, and the like as those of the press-fit terminal 1 of the first embodiment are denoted by the same reference numerals, a description thereof will be omitted, and only different components and parts will be described.

In the press-fit terminal 1d of the fifth embodiment, the shapes of outer wall surfaces 358a and 358b of a pair of press-fitting parts 350a and 350b and the shape of an open hole 308 are different from those of the outer wall surfaces 58a and 58b of the pair of press-fitting parts 50a and 50b and the shape of the open hole 8 in the press-fit terminal 1 of the first embodiment.

The outer wall surface 358a has a parallel portion 301a, a distal end portion 302a, and a proximal end portion 303a, and the outer wall surface 358b has a parallel portion 301b, a distal end portion 302b, and a proximal end portion 303b. The parallel portions 301a and 301b are portions that extend in parallel along the insertion direction X. The distal end portions 302a and 302b are portions that extend from the distal ends of the parallel portions 301a and 301b along the insertion direction X so as to be close to each other. The proximal end portions 303a and 303b are portions that extend from the proximal ends of the parallel portions 301a and 301b along a direction opposite to the insertion direction X so as to be close to each other.

As illustrated in FIG. 7, when viewed from the front, the open hole 308 has a vertically long approximately octagonal shape along the insertion direction X. The open hole 308 has a proximal end-side straight line portion 308a, a widened portion 308b, a parallel extending portion 308c, a reduced width portion 308d, and a distal end-side straight line portion 308e. The proximal end-side straight line portion 308a is a portion that is located on the proximal end side in the insertion direction X and extends along the first orthogonal direction Y. The widened portion 308b is a portion whose width dimension in the first orthogonal direction Y gradually increases along the insertion direction X from both ends of the proximal end-side straight line portion 308a in the first orthogonal direction Y. The parallel extending portion 308c is a portion that extends in parallel with the axial center Xt along the insertion direction X from the distal end of the widened portion 308b. The reduced width portion 308d is a portion whose width dimension in the first orthogonal direction Y gradually decreases along the insertion direction X from the distal end of the parallel extending portion 308c. The distal end-side straight line portion 308e is a portion that is located on the distal end side in the insertion direction X and extends along the first orthogonal direction Y. The parallel extending portion 308c includes a first center position 380a in the insertion direction X of the open hole 308. The proximal end-side straight line portion 308a and the distal end-side straight line portion 308e are parallel with each other.

A widened part 353 has a first contact point portion 354 adjacent to the introduction part 51, a second contact point portion 355 adjacent to the terminal part 52, and a low-rigidity portion 356 located between the first contact point portion 354 and the second contact point portion 355 in the insertion direction X, and extends along the insertion direction X.

The first contact point portion 354 has a first contact point 354a located on the distal end side in the insertion direction X. More specifically, in the first orthogonal direction Y, the first contact point 354a is located at the distal ends of the parallel portions 301a and 301b of the widened part 353 in the insertion direction X.

The second contact point portion 355 has a second contact point 355a located on the proximal end side in the insertion direction X. More specifically, in the first orthogonal direction Y, the second contact point 355a is located at the proximal ends of the parallel portions 301a and 301b of the widened part 353 in the insertion direction X.

The low-rigidity portion 356 is formed between the parallel extending portion 308c of the open hole 308 and the parallel portion 301a (301b), which faces the parallel extending portion 308c in the first orthogonal direction Y, in the first orthogonal direction Y. The low-rigidity portion 356 has the width dimension W8 in the first orthogonal direction Y. The open hole 308 has the largest width dimension in the first orthogonal direction Y in the low-rigidity portion 356, and its width dimension in the first orthogonal direction Y gradually decreases as being away from the low-rigidity portion 356 along the insertion direction X. Furthermore, the open hole 308 has the smallest width dimension in a portion adjacent to the proximal end-side straight line portion 308a and a portion adjacent to the distal end-side straight line portion 308e.

The widened part 353 has the same width dimension in the first orthogonal direction Y from the first contact point 354a to the second contact point 355a in the insertion direction X. In the press-fit terminal 1d of the fifth embodiment, the interval L2 along the insertion direction X between the first contact point 354a and the second contact point 355a is a dimension from the distal end side to the proximal end side in a portion where the width dimension in the first orthogonal direction Y is the same.

In the press-fit terminal 1d, the interval L2 along the insertion direction X between the first contact point 354a and the second contact point 355a is 70% to 100% of the depth dimension L3 of the through hole 23 in the insertion direction X. When the compliant part 5 is press-fitted into the inner peripheral surface of the through hole 23 and the coating 29 is scraped off by the first contact point 354a, since the first contact point 354a is deformed toward the open hole 8 side located inside with respect to the first orthogonal direction Y, force for scraping off the coating 29 is reduced. Thereafter, in the press-fit terminal 1d, the coating 29 is scraped off by a portion adjacent to the proximal end side of the first contact point 354a and deformation of the widened part 353 toward the open hole 8 side and scraping of the coating 29 by the widened part 353 are continued. In the press-fit terminal 1d of the fifth embodiment, since the interval L2 is large, it is possible to scrape off the coating 29 beyond the center position 24 of the through hole 23 in the insertion direction X, so that it is possible to reliably form an electrical contact point between the press-fit terminal 1d and the board 20. Consequently, the press-fit terminal 1d can appropriately perform electrical connection with the board 20.

In the press-fit terminal 1 of the first embodiment, the case where the first contact point 54a and the second contact point 55a come into contact with the inner peripheral surface of the through hole 23, as illustrated in FIG. 2, has been described. However, the invention is not limited thereto. The first contact point 54a may protrude to the outside of the through hole 23 from an opening located on the distal end side of the through hole 23 in the insertion direction X, and only the second contact point 55a may come into contact with the inner peripheral surface of the through hole 23.

The cases where the press-fit terminals 1, 1a, 1b, and 1c of the first to fourth embodiments have the hole having an approximately elliptical shape and the press-fit terminal 1d of the fifth embodiment has the open hole 308 having an approximately octagonal shape have been described. However, the invention is not limited thereto. When the press-fit terminals have a low-rigidity portion having a rigidity lower than that of a first contact point and that of a second contact point, the shapes of the holes are not limited to the above.

The press-fit terminals 1, 1a, 1b, and 1c of the first to fourth embodiments have been described in which the outer wall surfaces 58a, 158a, and 258a of the low-rigidity portions 56, 156, and 256 are recessed to be close to the open hole 8 with respect to the outer wall surfaces 58a, 158a, and 258a of the first contact points 54a, 154a, and 254a and the outer wall surfaces 58a, 158a, and 258a of the second contact points 55a, 155a, and 255a. The press-fit terminal 1d of the fifth embodiment has been described in which the outer wall surfaces 358a and 358b of the pair of press-fitting parts 350a and 350b each having the first contact point 354a, the second contact point 355a, and the low-rigidity portion 356 extend in parallel along the insertion direction X. However, the invention is not limited thereto and when the press-fit terminals have a low-rigidity portion having a rigidity lower than that of a first contact point and that of a second contact point, the shapes of the outer wall surfaces of the first contact point, the second contact point, the low-rigidity portion, and the press-fitting part are not limited to the above.

The press-fit terminal and the board with a terminal according to the present embodiment have the following configuration. The widened part has the first contact point that is a contact point located on the distal end side in the insertion direction, the second contact point that is a contact point located on the proximal end side opposite to the distal end side in the insertion direction, and the low-rigidity portion that is located between the first contact point and the second contact point in the insertion direction and has a rigidity lower than that of the first contact point and that of the second contact point. Therefore, the rigidity of the first contact point and the rigidity of the second contact point are higher than that of the low-rigidity portion. Thus, in the press-fit terminal, when the compliant part is press-fitted into the through hole, the amount of deformation of the low-rigidity portion toward the inside of an open hole is large and the amount of deformation of the first contact point toward the inside of the open hole and the amount of deformation of the second contact point toward the inside of the open hole are small. Therefore, one or both of the first contact point and the second contact point bite into the inner peripheral surface of the through hole, so that it is possible to achieve appropriate holding force with respect to the board and to appropriately perform electrical connection with the board.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A press-fit terminal (1) comprising:
a compliant part (5) that includes
a widened part (53) including contact points that protrude to an outermost side along an orthogonal direction (Y) orthogonal to an insertion direction (X) with respect to a through hole (23) of a board (20), and
an open hole (8) that allows deformation of the widened part (53) toward an inside in the orthogonal direction (Y), and is press-fitted into the through hole (23) along the insertion direction (X) to come into contact with an inner peripheral surface of the through hole (23) of the board (20), wherein
the widened part (53) has a first contact point (54a) that is the contact point located on a distal end side in the insertion direction (X), a second contact point (55a) that is the contact point located on a proximal end side opposite to the distal end side in the insertion direction (X), and a low-rigidity portion (56) that is located between the first contact point (54a) and the second contact point (55a) in the insertion direction (X) and has a rigidity lower than rigidity of the first contact point (54a) and rigidity of the second contact point (55a).

2. The press-fit terminal (1) according to claim 1, wherein
the compliant part (5) includes
a pair of press-fitting parts (50a, 50b) that extend along the insertion direction (X), are located to face each other with the open hole (8) interposed therebetween in the orthogonal direction (Y), and are each provided with the first contact point (54a), the second contact point (55a), and the low-rigidity portion (56),
each of the pair of press-fitting parts (50a, 50b) includes an inner wall surface (57a, 57b) located on a side of the open hole (8) in the orthogonal direction (Y) and an outer wall surface (58a, 58b) located on a side opposite to the open hole (8) in the orthogonal direction (Y), and
in the orthogonal direction (Y), a width dimension (W8) between the inner wall surface (57a, 57b) and the outer wall surface (58a, 58b) of the low-rigidity portion (56) is smaller than a width dimension (W9) between the inner wall surface (57a, 57b) and the outer wall surface (58a, 58b) of the first contact point (54a) and a width dimension (W10) between the inner wall surface (57a, 57b) and the outer wall surface (58a, 58b) of the second contact point (55a).

3. The press-fit terminal (1) according to claim 2, wherein
the outer wall surface (58a, 58b) of the low-rigidity portion (56) is recessed to be closed to the open hole (8) with respect to the first contact point (54a) and the second contact point (55a).

4. The press-fit terminal (1) according to claim 2, wherein
the outer wall surfaces (58a, 58b) of the pair of press-fitting parts (50a, 50b) extend in parallel along the insertion direction (X), and
the open hole (8) has a largest width dimension in the orthogonal direction (Y) in the low-rigidity portion (56) and a width dimension in the orthogonal direction (Y) gradually decreases as being away from the low-rigidity portion (56) along the insertion direction (X).

5. The press-fit terminal (1) according to one of claims 1 to 4, wherein
a coating (29) is located on the inner peripheral surface of the through hole (23) of the board (20), and
when the compliant part (5) is press-fitted into the inner peripheral surface of the through hole (23), the coating (29) is scraped off by the first contact point (54a).

6. The press-fit terminal (1) according to one of claims 1 to 5, wherein
an interval (L) along the insertion direction (X) between the first contact point (54a) and the second contact point (55a) is 70% to 100% of a depth dimension of the through hole (23) in the insertion direction (X).

7. A board (2) with a terminal, comprising:
a board (20) having a through hole (23); and
a press-fit terminal (1) press-fitted into the through hole (23), wherein
the press-fit terminal (1) includes
a compliant part (5) that includes a widened part (53) including contact points that protrude to an outermost side along an orthogonal direction (Y) orthogonal to an insertion direction (X) with respect to the through hole (23) of the board (20); and
an open hole (8) that allows deformation of the widened part (53) toward an inside in the orthogonal direction (Y), and is press-fitted into the through hole (23) along the insertion direction (X) to come into contact with an inner peripheral surface of the through hole (23) of the board (20), and
the widened part (53) has a first contact point (54a) that is the contact point located on a distal end side in the insertion direction (X), a second contact point (55a) that is the contact point located on a proximal end side opposite to the distal end side in the insertion direction (X), and a low-rigidity portion (56) that is located between the first contact point (54a) and the second contact point (55a) in the insertion direction (X) and has a rigidity lower than rigidity of the first contact point (54a) and rigidity of the second contact point (55a).
